# EUROPÄISCHE PATENTSCHRIFT

(11) **EP 1 909 338 B1**
(45) Veröffentlichungstag und Bekanntmachung des Hinweises auf die Patenterteilung: **24.07.2013**
(21) Anmeldenummer: 07115384.5
(22) Anmeldetag: 31.08.2007
(51) Int. Cl.: H01L 41/053, F02M 51/06

(54) **Anordnung eines Piezoaktors mit einer Isolationsschicht**
Piezo actuator assembly with an insulating layer
Dispositif piézoactionneur avec une couche d'isolation

(30) Priorität: 02.10.2006 DE 102006046831
(43) Veröffentlichungstag der Anmeldung: 09.04.2008
(73) Patentinhaber: ROBERT BOSCH GMBH, 70442 Stuttgart (DE)
(72) Erfinder: Boecking, Friedrich, 70499 Stuttgart (DE)

(56) Entgegenhaltungen:
- WO-A1-2007/131965
- JP-A- 2 094 680

## Beschreibung

### Stand der Technik

Die Erfindung betrifft eine Anordnung mit einem isolierten Piezoaktor, beispielsweise bei einem von flüssigen Medien umströmten Piezoaktor, der in einem Piezoinjektor zur zeitpunkt- und mengengenauen Dosierung von Kraftstoff in einem Verbrennungsmotor einsetzbar ist, nach den gattungsgemäßen Merkmalen des Hauptanspruchs.

Ein solcher Piezoinjektor besteht im Wesentlichen aus einem Haltekörper und dem in dem Haltekörper angeordneten Piezoaktor, der zwischen einem Aktorkopf und einem Aktorfuß angeordnete, übereinandergestapelte Piezoelemente mit Piezolagen aufweist.

Es ist an sich bekannt, dass zum Aufbau des zuvor erwähnten Piezoaktors die Piezoelemente so eingesetzt werden können, dass unter Ausnutzung des sogenannten Piezoeffekts eine Steuerung des Nadelhubes eines Ventils oder dergleichen vorgenommen werden kann. Die Piezolagen der Piezoelemente sind aus einem Material mit einer geeigneten Kristallstruktur so aufgebaut, dass bei Anlage einer äußeren elektrischen Spannung eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor ist ebenfalls ein Stapel mehrerer elektrisch und mechanisch miteinander gekoppelter Piezoelemente vorhanden, die über einen Aktorfuß und einen Aktorkopf unter Vorspannung zwischen zwei Anschlägen gehalten sind. Jede piezokeramische Schicht ist als Piezolage zur Bildung der Piezoelemente zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Um eine elektrische und mechanische Isolierung des Piezoaktors zu erreichen, wird oft auch eine flexible Ummantelung des Piezoaktors vorgeschlagen. Aus der DE 10230032 A1 ist zur Vermeidung von Beeinträchtigungen der Piezoelemente eine Anordnung mit einem Piezoaktor in umströmenden Medien bekannt, bei der die Piezoelemente in einer formveränderlichen Isolationsmasse vergossen sind, die wiederum in einem seitlich und am oberen und unteren Ende gegenüber dem Medium verschlossenen Gehäusemantel eingebracht ist, was einen großen Herstellungsaufwand erforderlich macht.

JP 2 094680 A offenbart einen Piezoaktor mit zwischen Metallkappen eingespannten Piezoelementen und mit einer zumindest die Piezoelemente umgebenden Isolationsschicht aus Kunststoff, wobei auf die Isolationsschicht und bis in die angrenzenden Randbereiche der Metallkappen die Enden einer Metallfolie mittels dichtendem Epoxy-Klebstoff mit den Metallkappen verbunden sind.

WO 2007/131965 offenbart einen Piezoaktor mit einem Piezoelement, bestehend aus einem Mehrschichtaufbau von Piezolagen, wobei der Piezoaktor im Bereich des Piezoelements mit mindestens einer Lage einer metallischen Folie umwickelt ist.

### Offenbarung der Erfindung

Die Erfindung geht von einer eingangs beschriebenen Anordnung mit einem Piezoaktor aus, der zwischen einem Aktorkopf und einem Aktorfuß eingespannte Piezoelemente aufweist und mit einer zumindest die Piezoelemente umgebenden Isolationsschicht aus Kunststoff versehen ist. Die Isolationsschicht und zumindest angrenzende Randbereiche des Aktorkopfs und des Aktorfußes sind mit mindestens einer Lage einer abdichtenden Metallfolie versehen.

Die aufgetragene mindestens eine Lage der Metallfolie weist einen relativ geringen Wärmeausdehnungskoeffizienten auf, damit die Metallfolie zusätzlich zum Hub des Piezoaktors nicht auch noch die Wärmedehnung des Piezoaktors ausgleichen muss, die durchaus auch in der Größenordnung seines Hubes liegen kann.

Insbesondere wenn der mit der erfindungsgemäßen Anordnung gebildete Piezoaktor Bestandteil eines Piezoinjektors für ein Einspritzsystem für Kraftstoff bei einem Verbrennungsmotor ist, kann der zu berücksichtigende Temperaturbereich für die Wärmedehnung zwischen -45C° und +140C° liegen.

Der Wärmeausdehnungskoeffizient des Piezoaktors beträgt erfindungsgemäß ca. -6* 10⁻⁶ 1/K. Damit die Metallfolie durch die Wärmedehnung des Piezoaktors nicht zu stark gedehnt wird, sollte die Metallfolie aus einem Material sein, dessen Wärmeausdehnungskoeffizient nahe dem von Keramik liegt (ca. -6 bis +6* 10⁻⁶ 1/K). Ein solches Material ist zum Beispiel Invar. Die mindestens eine Lage der Metallfolie kann dabei beispielsweise eine Schichtdicke von 2 bis 10 m aufweisen.

Insbesondere sind bei der Erfindung auch mehrlagige Metallfolienanordnungen, zum Beispiel bis zu fünf oder mehr Lagen, vorteilhaft, mit denen eine Reihe von Funktionen, wie Dichtheit, Isolation oder Flexibilität verbessert werden können, wobei jedoch auch einlagige Anordnungen, besonders wegen der einfachen Anbringung, sinnvoll sein können.

Während der Herstellung des Piezoaktors können die Lagen der Metallfolie flächig aufgetragen oder auch überlappend aufgewickelt werden.

### Kurze Beschreibung der Zeichnungen

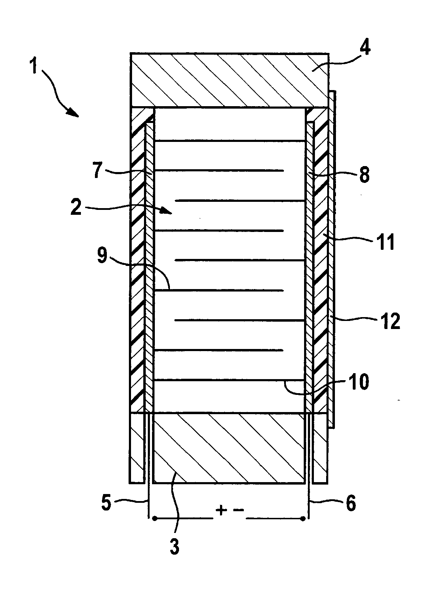

Ein Ausführungsbeispiel einer erfindungsgemäßen Anordnung mit einem Piezoaktor wird anhand der Zeichnung erläutert. Es zeigt:
Eine einzige Figur einen Längsschnitt durch eine Anordnung mit einem Piezoaktor mit einer Metallfolie, der Bestandteil eines hier nicht dargestellten Piezoinjektors sein kann.

### Ausführungsform der Erfindung

In der Figur ist ein eine Anordnung 1 mit einem Piezoaktor 2 mit beispielsweise eckiger oder runder Geometrie im Längsschnitt gezeigt, der zum Beispiel zur Nadelhubsteuerung in einem Einspritzsystem für Kraftstoff für einen Verbrennungsmotor eingesetzt werden kann. Der Piezoaktor 2 weist weiterhin noch einen Aktorfuß 3 und einen Aktorkopf 4, zum Beispiel aus Stahl, auf. Es sind elektrische Zuleitungen 6 und 7 durch den Aktorfuß 3 geführt, die über Außenelektroden 7 und 8 an Innenelektroden 9 und 10 kontaktiert sind.

Die Innenelektroden 9 und 10 bilden jeweils mit einer dazwischenliegenden Piezolage ein Piezoelement, sodass der Stapel aus den übereinanderliegenden Piezoelementen den agierenden Piezoaktor 2 bildet. Bei einer Betätigung des Piezoaktors 2 durch eine Spannungsbeaufschlagung der Innenelektroden 9 und 10 über die Zuleitungen 5 und 6 sowie über die Außenelektroden 7 und 8 kann eine am Aktorkopf 4 befindliche mechanische Anordnung durch den verursachten Hub betätigt werden.

Die Anordnung mit dem Piezoaktor 2 ist in einen hier nicht gezeigten Injektorkörper eingebaut, wobei der Kraftstoff durch den Innenraum des Injektorkörpers an der Anordnung 1 vorbeigeführt wird. Dieser Kraftstoff kann dann beispielsweise bei einem sogenannten Common Rail System (CR-System) unter dem in der Beschreibungseinleitung erwähnten Raildruck oder einem anderen vorgebbaren Druck des Kraftstoffs in den Brennraum eines hier nicht dargestellten Verbrennungsmotors injiziert werden.

Um den Piezoaktor 2 nach der Figur vor dem umströmenden Kraftstoff und vor sonstigen schädlichen Einwirkungen zu schützen, ist eine insbesondere flexible Isolationsschicht 11 aus Kunststoff vorhanden, die wiederum mit einer Metallfolie 12 versehen ist.

Die erfindungsgemäß aufgetragene mindestens eine Lage der Metallfolie 12, zum Beispiel aus Invar, weist einen relativ geringen Wärmeausdehnungskoeffizienten auf, damit Wärmedehnungen ausgeglichen werden können, die eventuell in der Größenordnung des Hubes des Piezoaktors 2 liegen. Dies ist vor allem dann von Bedeutung, wenn der Piezoaktor 2 Bestandteil eines Piezoinjektors für ein Einspritzsystem für Kraftstoff bei einem Verbrennungsmotor ist und der zu berücksichtigende Temperaturbereich zwischen -45 C° und +140 C° liegen kann.

Die Metallfolie 12 reicht dabei zumindest bis in die angrenzenden Randbereiche des Aktorkopfs 4 und/oder des Aktorfußes 3, damit die mindestens eine Lage der Metallfolie 12 auch dichtend auf die Piezoelemente bzw. den Piezoaktor 2 aufgetragen werden kann.

## Patentansprüche

1. Anordnung mit einem Piezoaktor (2) mit zwischen einem Aktorkopf (4) und einem Aktorfuß (3) eingespannten Piezoelementen und mit einer zumindest die Piezoelemente umgebenden Isolationsschicht (11) aus Kunststoff, wobei auf die Isolationsschicht (11) und zumindest bis in die angrenzenden Randbereiche des Aktorkopfs (3) und/oder des Aktorfußes (3) mindestens eine Lage einer Metallfolie (12) abdichtend aufgetragen ist,
**dadurch gekennzeichnet, dass** die mindestens eine Lage der Metallfolie (12) einen Wärmeausdehnungskoeffizienten
mit einem Betrag von ca. 0 bis 6* 10⁻⁶ 1/K aufweist.

2. Anordnung nach Anspruch 1, **dadurch gekennzeichnet, dass** die mindestens eine Lage der Metallfolie (12) eine Schichtdicke von 2 bis 10 µm aufweist.

3. Anordnung nach einem der vorhergehenden Ansprüche, **dadurch gekennzeichnet, dass** die mindestens eine Lage der Metallfolie (12) aus Invar ist

4. Anordnung nach einem der vorhergehenden Ansprüche, **dadurch gekennzeichnet, dass** zwei bis fünf Lagen der Metallfolie (12) aufgetragen sind.

5. Anordnung nach einem der vorhergehenden Ansprüche, **dadurch gekennzeichnet, dass** die mindestens eine Lage der Metallfolie (12) flächig aufgetragen ist.

6. Anordnung nach einem der Ansprüche 1 bis 4, **dadurch gekennzeichnet, dass** die mindestens eine Lage der Metallfolie (12) überlappend aufgewickelt ist.

7. Anordnung nach einem der vorhergehenden Ansprüche, **dadurch gekennzeichnet, dass** der in der Anordnung gebildete Piezoaktor (2) Bestandteil eines Piezoinjektors für ein Einspritzsystem für Kraftstoff bei einem Verbrennungsmotor ist, wobei der Kraftstoff die Metallfolie (12) des Piezoaktors (2) umströmt.

## Claims

1. Arrangement having a piezo actuator (2) with piezo elements braced between an actuator head (4) and an actuator foot (3) and having at least one insulation ply (11) which surrounds the piezo elements and which is composed of plastic, wherein at least one layer of a metal foil (12) is sealingly applied to the insulation ply (11) and at least as far as into the adjoining edge regions of the actuator head (4) and/or of the actuator foot (3), **characterized in that** the at least one layer of the metal foil (12) has a coefficient of thermal expansion of approximately 0 to 6*10⁻⁶ 1/K.

2. Arrangement according to Claim 1, **characterized in that** the at least one layer of the metal foil (12) has a ply thickness of 2 to 10 µm.

3. Arrangement according to one of the preceding claims, **characterized in that** the at least one layer of the metal foil (12) is composed of Invar steel.

4. Arrangement according to one of the preceding claims, **characterized in that** two to five layers of the metal foil (12) are applied.

5. Arrangement according to one of the preceding claims, **characterized in that** the at least one layer of the metal foil (12) is applied areally.

6. Arrangement according to one of Claims 1 to 4, **characterized in that** the at least one layer of the metal foil (12) is wound on in an overlapping fashion.

7. Arrangement according to one of the preceding claims, **characterized in that** the piezo actuator (2) formed in the arrangement is a constituent part of a piezo injector for an injection system for fuel in an internal combustion engine, wherein the fuel flows around the metal foil (12) of the piezo actuator (2).

## Revendications

1. Agencement comprenant un piézoactionneur (2) avec des éléments piézoélectriques serrés entre une tête d'actionneur (4) et une base d'actionneur (3) et avec une couche d'isolation (11) en plastique entourant au moins les éléments piézoélectriques, au moins une couche d'un film métallique (12) étant appliquée de manière hermétique sur la couche d'isolation (11) et au moins jusque dans les régions de bord adjacentes de la tête d'actionneur (4) et/ou de la base d'actionneur (3),
**caractérisé en ce que** l'au moins une couche de film métallique (12) présente un coefficient de dilatation thermique compris entre environ 0 et 6*10⁻⁶ 1/K.

2. Agencement selon la revendication 1, **caractérisé en ce que** l'au moins une couche de film métallique (12) présente une épaisseur de couche de 2 à 10 µm.

3. Agencement selon l'une quelconque des revendications précédentes, **caractérisé en ce que** l'au moins une couche de film métallique (12) est en Invar.

4. Agencement selon l'une quelconque des revendications précédentes, **caractérisé en ce que** de deux à cinq couches de film métallique (12) sont appliquées.

5. Agencement selon l'une quelconque des revendications précédentes, **caractérisé en ce que** l'au moins une couche de film métallique (12) est appliquée à plat.

6. Agencement selon l'une quelconque des revendications 1 à 4, **caractérisé en ce que** l'au moins une couche de film métallique (12) est enroulée avec chevauchement.

7. Agencement selon l'une quelconque des revendications précédentes, **caractérisé en ce que** le piézoactionneur (2) formé dans l'agencement fait partie d'un injecteur piézoélectrique pour un système d'injection de carburant dans un moteur à combustion interne, le carburant circulant autour du film métallique (12) du piézoactionneur (2).
